# EUROPEAN PATENT SPECIFICATION

(11) **EP 0 390 360 B1**
(45) Date of publication and mention of the grant of the patent: **20.09.1995**
(21) Application number: 90302627.6
(22) Date of filing: 13.03.1990
(51) Int. Cl.: H03F 1/32, H03F 3/24, H03F 1/02, H03G 3/20

(54) **A method for changing the operating class of a transmitter**
Vorrichtung zur Änderung der Betriebsklasse eines Senders
Procédé pour changer la classe de fonctionnement d'un émetteur

(30) Priority: 29.03.1989 FI 891514
(43) Date of publication of application: 03.10.1990
(73) Proprietor: NOKIA MOBILE PHONES LTD., 24101 Salo (FI)
(72) Inventor: Vaisanen, Risto, SF-24100 Salo (FI); Pekkarinen, Vesa, SF-24100 Salo (FI); Sarasmo, Jukka, SF-24260 Salo (FI)
(74) Representative: Gilding, Martin John

(56) References cited:
- EP-A- 0 323 059
- US-A- 3 984 783
- US-A- 4 077 013
- US-A- 4 087 761

## Description

The invention relates to a method for changing the operating class of a transmitter when the transmitter comprises several power stages of class A, AB, B or C.

With the aid of the power stage of a radio telephone transmitter, the regulation of low power levels should be easy to carry out and at high powers the efficiency of the power stage should be maximal. The power spectrum produced when the transmitter is started up should widen as little as possible. In practice a power stage is a compromise with respect to these contradictory requirements. Usually in practice the power stage is a class C power amplifier. A class C amplifier has high efficiency, but the regulation of the power levels is difficult to carry out. In a class AB amplifier the regulation of power is easy to carry out, since a class AB amplifier functions more linearly than a class C amplifier. A class AB amplifier has the disadvantage of low efficiency. Especially in hand telephones, high efficiency is an important property to be aimed at, since it lengthens the operating time of a battery-operated telephone and reduces the heating up of the power stage.

US4077013, which forms the basis for the pre-characterising portion of Claim 1, discloses a power amplifying circuit having an output amplifier which can operate as a Class B or Class AB amplifier.

US3984783 discloses an amplifying circuit capable of providing the gain and linearity of a Class A amplifier and power conversion efficiency of a Class B or C amplifier.

The object of the present invention is to provide a method for use in the transmitter of a radio telephone, especially a radio telephone used in a digital GSM system, the transmitter being capable of eliminating disadvantages of prior art power stages.

The present invention provides a method for controlling the operation of a power stage according to the appended claims.

By changing the operating point, an amplifier of class A, B, AB or C can be converted into another amplifier of the said group. If the power stage has several power stages coupled in succession, the operating point of each amplifier is controlled independently, whereby the desired combination of amplifiers of the desired class is obtained. The control is effected by supplying a predetermined bias voltage to the base of the power transistor. The switching transistor is controlled by means of the microprocessor of the radio telephone.

The method according to the invention is described in greater detail with reference to the accompanying figures, in which
Figure 1 depicts a simplified circuitry of one power stage, with the control according to the invention, and
Figure 2 depicts the principle of the control in a multiple-stage power stage circuitry.

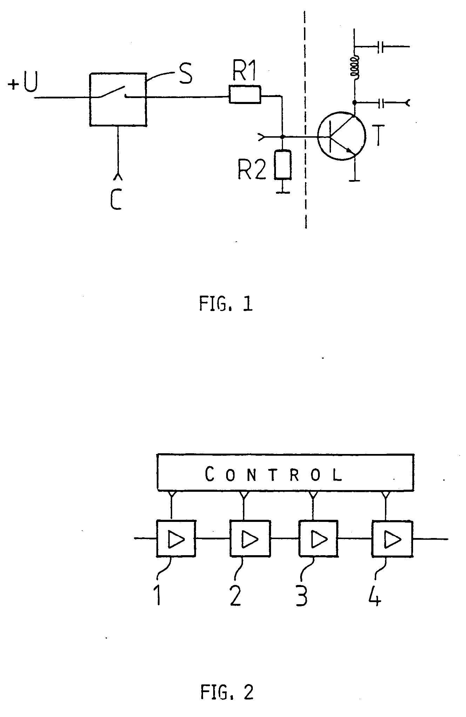

Figure 1 shows in a simplified manner a power stage, which is here represented by one power transistor T with is peripheral components. The power stage is on the right-hand side of the vertical dashed line in the figure. In accordance with the invention, the operating point of the power transistor T is changed by means of a switch S, which a microprocessor (not shown) controls from the control line c. When the switch is open, the power stage operates in class C and the operating point is determined by the base resistance R2. When the switch S is closed, the voltage divider R1-R2 is connected to the supply voltage U of the device, whereupon the transistor base voltage increases and the operating point of the transistor T changes. The amplifier now becomes, for example, a class AB amplifier.

If, in accordance with Figure 2, the power stage of the transmitter comprises several successively coupled power amplifiers 1, 2, 3 and 4, separate control is provided for each of them. By means of each individual control it is possible to switch each amplifier as an amplifier of the desired class. By suitably varying the class at different power levels it is possible suitably to optimize the result with respect to the transmitter efficiency, the regulation of low power levels, and the widening of the power spectrum produced at the start-up. The control of the amplifiers coupled in succession is implemented using the microprocessor of the radio telephone.

In a preferred embodiment of the invention, an amplifier can be switched between two classes. At low power levels the amplifier is switched as a class AB amplifier, and at high power levels it is switched as a class C amplifier. The adaptations between the amplifier stages are implemented so as to be dependent as little as possible on the change of the base impedance of the power transistor when the operating point changes.

By the method according to the invention, an optimal switching of the amplifier or the amplifier stages is obtained in accordance with the power level, whereupon the best possible efficiency can be optimized for the transmitter.

## Claims

1. A method for controlling the operation of a power stage including an amplifier (1,2,3,4) which includes at least an amplifier transistor (T) and a controllable switch (S) for changing the operating point of the amplifier transistor (T) characterised in that the method is suitable for the power stage of a radio telephone transmitter and in that a plurality of said amplifiers (1,2,3,4) are connected in succession and the operating point of each amplifier transistor (T) and thereby the operating class (A,B,AB,C) of each of the amplifiers (1,2,3,4) is selected individually by controlling separately the switch (S) of each of the amplifiers whereby the desired combination of amplifiers of the desired class is obtained for obtaining the desired operation of the radio transmitter.

2. A method according to Claim 1, characterised in that each controllable switch (S) is a transistor switch, the opening and closing of which is controlled via a control line (c), in which case, when the state of the switch (S) changes, the base voltage of the amplifier transistor (T) changes and at the same time the operation class (A,B,AB,C) of the amplifier (1,2,3,4) changes.

3. A method according to Claim 1 or 2, characterised in that the operating class of each of the amplifiers (1,2,3,4) is selected individually by a radio telephone microprocessor, which controls the opening and closing of the switches (S) of the amplifiers.

4. A method according to any of the preceding claims, characterised in that at least one of the amplifiers (1,2,3,4) is controlled to operate in Class C at high power levels and in Class AB at low power levels.

## Patentansprüche

1. Verfahren zur Steuerung des Betriebs einer Leistungsstufe mit einem Verstärker (1, 2, 3, 4), der wenigstens einen Verstärkungstransistor (T) und einen steuerbaren Schalter (S) zur Änderung des Arbeitspunkts des Verstärkungstransistors (T) aufweist, **dadurch gekennzeichnet**, daß sich das Verfahren für die Leistungsstufe eines Radiofon-Senders eignet, mehrere der Verstärker (1, 2, 3, 4) in Reihe miteinander verbunden sind, und der Arbeitspunkt eines jeden Verstärkungstransistors (T) und somit die Betriebsklasse (A, B, AB, C) eines jeden Verstärkers (1, 2, 3, 4) individuell durch separate Ansteuerung des Schalters (S) eines jeden Verstärkers auswählbar ist, wodurch die gewünschte Kombination der Verstärker der gewünschten Klasse und damit der gewünschte Betrieb des Radiosenders erhalten wird.

2. Verfahren nach Anspruch 1, **dadurch gekennzeichnet**, daß jeder steuerbare Schalter (S) ein Transistorschalter ist, der durch Steuerung über eine Steuerleitung (c) geöffnet und geschlossen wird, wobei sich dann, wenn sich der Zustand der Schalters (S) ändert, die Basisspannung des Verstärkungstransistors (T) ändert und zur selben Zeit die Betriebsklasse (A, B, AB, C) des Verstärkers (1, 2, 3, 4).

3. Verfahren nach Anspruch 1 oder 2, **dadurch gekennzeichnet**, daß die Betriebsklasse eines jeden Verstärkers (1, 2, 3, 4) individuell durch einen Radiofon-Mikroprozessor ausgewählt wird, der das Öffnen und Schließen der Schalter (S) der Verstärker steuert.

4. Verfahren nach einem der vorhergehenden Ansprüche, **dadurch gekennzeichnet**, daß wenigstens einer der Verstärker(1, 2, 3, 4) so angesteuert wird, daß er in Klasse C bei hohen Leistungspegeln und in Klasse AB bei niedrigen Leistungspegeln arbeitet.

## Revendications

1. Procédé de commande du fonctionnement d'un étage de puissance comprenant un amplificateur (1, 2, 3, 4) lequel comprend au moins un transistor amplificateur (T) et un commutateur commandable (S) destiné à modifier le point de fonctionnement du transistor amplificateur (T) caractérisé en ce que le procédé convient à l'étage de puissance d'un émetteur de radio téléphone et en ce qu'une pluralité desdits amplificateurs (1, 2, 3, 4) sont reliés à la suite et que le point de fonctionnement de chaque transistor amplificateur (T) et de ce fait la classe de fonctionnement (A, B, AB, C) de chacun des amplificateurs (1, 2, 3, 4) est sélectionnée individuellement en commandant séparément le commutateur (S) de chacun des amplificateurs d'où il résulte que la combinaison désirée des amplificateurs de la classe désirée est obtenue afin d'obtenir le fonctionnement désiré de l'émetteur radio.

2. Procédé selon la revendication 1, caractérisé en ce que chaque commutateur commandable (S) est un commutateur à transistor, l'ouverture et la fermeture de celui-ci sont commandées par l'intermédiaire d'une ligne de commande (C), auquel cas, lorsque l'état du commutateur (S) change, la tension de base du transistor amplificateur (T) change et en même temps la classe de fonctionnement (A, B, AB, C) de l'amplificateur (1, 2, 3, 4) change.

3. Procédé selon la revendication 1 ou la revendication 2, caractérisé en ce que la classe de fonctionnement de chacun des amplificateurs (1, 2, 3, 4) est sélectionnée individuellement au moyen d'un microprocesseur de radio téléphone, lequel commande l'ouverture et la fermeture des commutateurs (S) des amplificateurs.

4. Procédé selon l'une quelconque des revendications précédentes, caractérisé en ce qu'au moins d'un des amplificateurs (1, 2, 3, 4) est commandé pour fonctionner en classe C aux niveaux de puissance élevés et en classe AB aux niveaux de puissance faibles.
